# EUROPEAN PATENT APPLICATION

(11) **EP 4 362 617 A1**
(43) Date of publication of application: **01.05.2024**
(21) Application number: 23206147.3
(22) Date of filing: 26.10.2023
(51) Int. Cl.: H05K 7/14, H05K 7/20

(54) **ACDC MODULE, DCDC MODULE, AND CHARGING SYSTEM**

(30) Priority: 29.10.2022 CN 202222892408 U
(71) Applicant: Huawei Digital Power Technologies Co., Ltd., Shenzhen, Guangdong 518043 (CN)
(72) Inventor: LIU, Yaping, Shenzhen, 518043 (CN); CHEN, Jiansheng, Shenzhen, 518043 (CN); LV, Zejie, Shenzhen, 518043 (CN); LI, Yongfa, Shenzhen, 518043 (CN)
(74) Representative: Gill Jennings & Every LLP

(57) **Abstract**

This application provides an ACDC module, a DCDC module, and a charging system. The ACDC module includes a housing, an AC input terminal, a DC output terminal, and a signal terminal. The housing includes a first sidewall. A part of the AC input terminal, a part of the DC output terminal, and a part of the signal terminal are all located inside the housing. The other part of the AC input terminal, the other part of the DC output terminal, and the other part of the signal terminal all pass through the first sidewall and extend out of the housing. The AC input terminal, the DC output terminal, and the signal terminal are arranged in a length direction of the first sidewall. When a conducting wire is arranged between a plurality of ACDC modules, a length of the conducting wire is short, and the conducting wire is arranged more neatly. When the ACDC module and the DCDC module are used in the charging system, a structure of the charging system is simplified.

## Description

### TECHNICAL FIELD

This application relates to the field of new energy vehicles, and in particular, to an ACDC module, a DCDC module, and a charging system.

### BACKGROUND

With development of electric vehicle technologies, electric vehicles become increasingly mature and are gradually accepted by consumers. A charging pile is an energy supply station of an electric vehicle, and includes an ACDC module and a DCDC module. The ACDC module is configured to convert an alternating current into a direct current. The DCDC module is configured to convert a high-voltage direct current into a direct current for powering an electric vehicle. However, because structures of the ACDC module and the DCDC module are not properly disposed, a conducting wire that is electrically connected between two ACDC modules and a conducting wire that is electrically connected between the ACDC module and the DCDC module need to bypass a plurality of components or modules. In this way, the conducting wire that is electrically connected between the two ACDC modules and the conducting wire that is electrically connected between the ACDC module and the DCDC module are long, and are arranged in disorder. Therefore, complexity of a structure of a charging pile and assembly difficulty of the charging pile are increased.

### SUMMARY

This application provides an ACDC module and a DCDC module. When the ACDC module and the DCDC module are used in a charging system, a structure of the charging system is simplified, and assembly difficulty of the charging system is reduced.

According to a first aspect, an embodiment of this application provides an ACDC module. The ACDC module includes a housing, an AC input terminal, a DC output terminal, and a signal terminal. The housing includes a first sidewall. A part of the AC input terminal, a part of the DC output terminal, and a part of the signal terminal are all located inside the housing. The other part of the AC input terminal, the other part of the DC output terminal, and the other part of the signal terminal all pass through the first sidewall and extend out of the housing. The AC input terminal, the DC output terminal, and the signal terminal are arranged in a length direction of the first sidewall.

It may be understood that the AC input terminal, the DC output terminal, and the signal terminal of the ACDC module are arranged on the first sidewall in the length direction of the first sidewall. This facilitates flat arrangement of the ACDC module. When a conducting wire is arranged between a plurality of ACDC modules, the conducting wire may not bypass a structure such as the AC input terminal, the DC output terminal, or the signal terminal. Therefore, a length of the conducting wire may be reduced, and the conducting wire is arranged more neatly. When the ACDC module is used in the charging system, the structure of the charging system is simplified, and assembly difficulty of the charging system is reduced.

In an implementation, the AC input terminal includes a first phase current input port, a second phase current input port, and a third phase current input port that are disposed spaced from one another. The first phase current input port, the second phase current input port, and the third phase current input port are arranged in the length direction of the first sidewall.

It may be understood that compared with a solution in which the first phase current input port, the second phase current input port, and the third phase current input port are arranged in a height direction of the first sidewall (that is, a thickness direction of the ACDC module), the first phase current input port, the second phase current input port, and the third phase current input port are arranged in the length direction of the first sidewall. When the conducting wire is arranged between AC input terminals of the plurality of ACDC modules, there may be no barrier between input ports to be electrically connected. Therefore, the length of the conducting wire may be reduced, and the conducting wire is arranged more neatly. When the ACDC module is used in the charging system, the structure of the charging system is simplified, and assembly difficulty of the charging system is reduced.

In an implementation, the DC output terminal includes a positive output port and a negative output port that are disposed spaced from each other. The positive output port and the negative output port are arranged in the length direction of the first sidewall.

It may be understood that compared with a solution in which the positive output port and the negative output port of the DC output terminal are arranged in the height direction of the first sidewall (that is, the thickness direction of the ACDC module), the positive output port and the negative output port are arranged in the length direction of the first sidewall. When a conducting wire is arranged between DC output terminals of the plurality of ACDC modules, there is no barrier between ports to be electrically connected and the conducting wire does not need to bypass some structures on the first sidewall. Therefore, the length of the conducting wire may be reduced, and the conducting wire is arranged more neatly. When the ACDC module is used in the charging system, the structure of the charging system is simplified, and assembly difficulty of the charging system is reduced.

In an implementation, the DC output terminal is located between the AC input terminal and the signal terminal.

It may be understood that the AC input terminal is located on one side of the DC output terminal, and the AC input terminal side may be connected to a three-phase alternating current from the outside. In this way, the conducting wire does not need to bypass the DC output terminal or the signal terminal. Therefore, the length of the conducting wire may be reduced, and the conducting wire is arranged more neatly. When the ACDC module is used in the charging system, the structure of the charging system is simplified, and assembly difficulty of the charging system is reduced.

In an implementation, the housing includes a second sidewall and a bottom wall. The second sidewall is connected to the first sidewall. The second sidewall and the first sidewall are disposed at an included angle. The bottom wall is connected to the first sidewall and the second sidewall, and is located at a bottom of the first sidewall and a bottom of the second sidewall.

A projection of the AC input terminal on the second sidewall is a first projection. A projection of the DC output terminal on the second sidewall is a second projection. A projection of the AC input terminal on the bottom wall is a third projection. A projection of the DC output terminal on the bottom wall is a fourth projection. The first projection and the second projection at least partially overlap. The third projection and the fourth projection are staggered.

It may be understood that in one aspect, compared with a solution in which the first projection and the second projection are staggered, the first projection and the second projection at least partially overlap. In a direction perpendicular to the bottom wall, a thickness of an overlapping part may be reduced, so that a thickness of the ACDC module is smaller. In another aspect, the third projection and the fourth projection are staggered. In this way, the AC input terminal and the DC output terminal are disposed side by side, and are not stacked. This facilitates flat arrangement of the ACDC module. When the ACDC module is electrically connected to the DCDC module, or the two ACDC modules are electrically connected, there is no barrier between positions to be electrically connected. Therefore, the length of the conducting wire between the modules may be reduced, and the conducting wire is arranged more neatly.

In an implementation, a projection of the signal terminal on the second sidewall is a fifth projection. A projection of the signal terminal on the bottom wall is a sixth projection. The second projection and the fifth projection at least partially overlap. The fourth projection and the sixth projection are staggered.

It may be understood that the second projection and the fifth projection at least partially overlap, so that the thickness of the ACDC module may be further reduced.

In an implementation, the ACDC module includes a circuit board. The circuit board is disposed inside the housing. The AC input terminal, the DC output terminal, and the signal terminal are electrically connected to the circuit board.

The bottom wall includes a top surface and a bottom surface that are disposed back to each other. The bottom surface is a surface of a side that is of the bottom wall and that is away from the circuit board. A first groove is disposed on the bottom wall. An opening of the first groove is located on the bottom surface of the bottom wall. The housing further includes a second cover. The second cover is fastened to the bottom wall and covers the first groove. The second cover cooperates with the first groove to form a runner. The runner is configured to circulate a coolant to cool the circuit board.

It may be understood that the runner may be configured to circulate the coolant. The coolant may be cooling water. The coolant is configured to take away heat when the circuit board works. Therefore, an objective of cooling is achieved and a fault of the circuit board caused by an excessively high operating temperature is avoided.

In addition, the runner through which the coolant flows is disposed on the bottom wall of the housing, and there is no need to additionally dispose a cooling plate used for liquid cooling. In this way, assembly difficulty of the ACDC module is reduced, an installation procedure is simplified, and product competitiveness is improved. The bottom wall of the housing has a function of a cooling plate. In addition, the housing may be further configured to load parts such as the circuit board, the AC input terminal, the DC output terminal, the signal terminal, and the like. The housing has a function of "one object for two purposes". In addition, because the coolant directly flows through the runner in the housing, there is no need to additionally design a pipe through which the coolant flows in the internal space of the housing. This helps reduce a size of the ACDC module.

In addition, the ACDC module applies a liquid cooling mode. Compared with an air cooling mode, the liquid cooling mode has a small noise, is not prone to dust accumulation, and does not have problems of salt spray corrosion and air channel blocking. The ACDC module is easy to maintain and has a long service life.

In an implementation, the housing includes a third sidewall. The first sidewall and the third sidewall are oppositely disposed spaced from each other. A second sidewall is connected between the first sidewall and the third sidewall. The bottom wall is connected to the first sidewall, the second sidewall, and the third sidewall, and is located at a bottom of the first sidewall, a bottom of the second sidewall, and a bottom of the third sidewall. A liquid inlet and a liquid outlet are disposed on the third sidewall. The liquid inlet and the liquid outlet are disposed spaced from each other. The liquid inlet communicates with the runner, and the liquid outlet communicates with the runner. The coolant can flow into the runner through the liquid inlet, flow to the liquid outlet through the runner, and flow out of the housing through the liquid outlet.

It may be understood that in this way, the liquid inlet and the liquid outlet are disposed opposite to the AC input terminal, the DC output terminal, and the signal terminal of the ACDC module. This can avoid to a maximum extent a problem of electric leakage caused by coolant leakage.

In an implementation, both the AC input terminal and the DC output terminal are of a floating structure.

It may be understood that the AC input terminal and the DC output terminal apply a floating structure, and when the ACDC module is installed, this facilitates quick implementations of blind insertion, quick connection, or quick separation between the ACDC module and various plugs. This reduces the risks of faults including shifting, skewness, misplacement, jamming, and the like during removal and insertion, and improves the reliability and service life of a device.

In an implementation, the ACDC module further includes a guide pin. The guide pin is connected to the first sidewall, and the guide pin is configured to assist in positioning the ACDC module in the charging system.

It may be understood that the guide pin is disposed, so that when the ACDC module is installed in the charging system, the guide pin may be configured to assist in positioning the ACDC module. This helps quickly install the ACDC module, implement precise positioning, reduce a risk of an installation error, and improve installation efficiency.

In an implementation, the ACDC module further includes a display component. The display component is connected to the third sidewall, and the display component is configured to display a current operating state of the ACDC module.

It may be understood that a user may analyze the current operating state of the ACDC module based on a prompt of the display component. When the ACDC module is faulty, the display component may help the user analyze a fault cause.

In an implementation, the ACDC module further includes a ground screw. The ground screw is located on the third sidewall, and the ground screw is used for grounding.

It may be understood that when the ACDC module is faulty and an electric leakage problem occurs, the ground screw may conduct a current to the ground. This reduces a risk of an accidental injury of a person.

In an implementation, the ACDC module includes a circuit board. The circuit board is disposed inside the housing. The AC input terminal, the DC output terminal, and the signal terminal are electrically connected to the circuit board.

When there is one circuit board, the circuit board is disposed parallel to the bottom wall.

When there are a plurality of circuit boards, the plurality of circuit boards are located on a same plane and are disposed parallel to the bottom wall.

It may be understood that the circuit board is disposed parallel to the bottom wall, and slight deviation is allowed. For example, the circuit board and the bottom wall may be disposed at an included angle of 5 degrees, 10 degrees, or 15 degrees.

In an implementation, the housing includes a first nozzle and a second nozzle. The first nozzle is connected to an inner wall surface of the liquid inlet, and the second nozzle is connected to an inner wall surface of the liquid outlet.

It may be understood that the first nozzle and the second nozzle may be configured to control a flow speed of the coolant in the runner.

In an implementation, the ACDC module further includes a handle. The handle is connected to the first sidewall, and the handle and the housing form an integrated structural component.

It may be understood that, that two parts are integrally molded into an integrated structural component means that in a process of forming one part of the two parts, the part is connected to the other part, and the two parts do not need to be connected together in a manner of reprocessing (for example, bonding, welding, fastener connection, or screw connection).

The handle may be configured to facilitate the user to grasp the ACDC module. The handle and the housing form an integrated structural component. The handle is unlikely to be disconnected from the housing, and strength of the handle is higher.

In an implementation, the housing further includes side lugs. A quantity of the side lugs is two. The two side lugs are respectively located at two ends of the third sidewall. One side lug is connected to the second sidewall, and the other side lug is connected to a fourth sidewall.

It may be understood that the side lugs are configured to help fasten the ACDC module to an outer frame of the charging system.

In an implementation, a first holding groove is disposed on the second sidewall, and an opening of the first holding groove is located on the second sidewall and the bottom wall. A second holding groove is disposed on the fourth sidewall, and an opening of the second holding groove is located on the fourth sidewall and the bottom wall.

It may be understood that the first holding groove and the second holding groove may be used as lifting handles of the ACDC module. This facilitates grasping the ACDC module when the ACDC module is taken and placed. In addition, the first holding groove and the second holding groove are designed in a groove form. In this way, a width of a housing body is not increased, and it is avoided that the ACDC module occupies excessively large space in the charging system.

In an implementation, the housing further includes the fourth sidewall. The fourth sidewall and the second sidewall are oppositely disposed spaced from each other, and the fourth sidewall is connected between the first sidewall and the third sidewall. The bottom wall is connected to the first sidewall, the second sidewall, the third sidewall, and the fourth sidewall, and is located at a bottom of the first sidewall, a bottom of the second sidewall, a bottom of the third sidewall, and a bottom of the fourth sidewall.

The housing includes a first cover. The first cover, the first sidewall, the second sidewall, the third sidewall, the fourth sidewall, and the bottom wall enclose an accommodation space, and the circuit board is disposed in the accommodation space.

It may be understood that the first cover, the first sidewall, the second sidewall, the third sidewall, the fourth sidewall, and the bottom wall enclose the accommodation space, and the circuit board is disposed in the accommodation space. The first cover, the first sidewall, the second sidewall, the third sidewall, the fourth sidewall, and the bottom wall may protect the circuit board to avoid impact of an external environment on the circuit board.

According to a second aspect, an embodiment of this application provides a DCDC module. The DCDC module includes a housing, a DC input terminal, a DC output terminal, and a signal terminal. The housing includes a first sidewall. A part of the DC input terminal, a part of the DC output terminal, and a part of the signal terminal are all located inside the housing. The other part of the DC input terminal, the other part of the DC output terminal, and the other part of the signal terminal all pass through the first sidewall and extend out of the housing. The DC input terminal, the DC output terminal, and the signal terminal are arranged in a length direction of the first sidewall.

It may be understood that the DC input terminal, the DC output terminal, and the signal terminal of the DCDC module are arranged in the length direction of the first sidewall. This facilitates flat arrangement of the DCDC module. When a conducting wire is arranged between a plurality of DCDC modules, the conducting wire does not need to bypass a structure such as the DC input terminal, the DC output terminal, or the signal terminal. Therefore, a length of the conducting wire may be reduced, and the conducting wire is arranged more neatly. When the DCDC module is used in a charging system, a structure of the charging system is simplified, and assembly difficulty of the charging system is reduced.

In an implementation, the DC input terminal includes a positive input port and a negative input port that are disposed spaced from each other. The positive input port and the negative input port are arranged in the length direction of the first sidewall.

It may be understood that compared with a solution in which the positive input port and the negative input port of the DC input terminal are arranged in a height direction of the first sidewall (that is, a thickness direction of the DCDC module), the positive input port and the negative input port of the DC input terminal are arranged in the length direction of the first sidewall. When the conducting wire is arranged between DC input terminals of the plurality of DCDC modules, there may be no barrier between ports to be electrically connected. Therefore, the length of the conducting wire may be reduced, and the conducting wire is arranged more neatly. When the DCDC module is used in the charging system, the structure of the charging system is simplified, and assembly difficulty of the charging system is reduced.

In an implementation, the DC output terminal includes a positive output port and a negative output port that are disposed spaced from each other. The positive output port and the negative output port are arranged in the length direction of the first sidewall.

It may be understood that compared with a solution in which the positive output port and the negative output port of the DC output terminal are arranged in the height direction of the first sidewall (that is, the thickness direction of the DCDC module), the positive output port and the negative output port are arranged in the length direction of the first sidewall. When the conducting wire is arranged between DC output terminals of the plurality of DCDC modules, there may be no barrier between ports to be electrically connected. Therefore, the length of the conducting wire may be reduced, and the conducting wire is arranged more neatly. When the DCDC module is used in the charging system, the structure of the charging system is simplified, and assembly difficulty of the charging system is reduced.

In an implementation, the DC input terminal is located between the DC output terminal and the signal terminal.

It may be understood that the DC output terminal is located on one side of the DC input terminal. When the DC output terminal is electrically connected to a to-be-charged device, a conducting wire may be arranged from one side. In this way, the conducting wire does not need to bypass the DC input terminal, the length of the conducting wire may be reduced, and the conducting wire is arranged more neatly. When the DCDC module is used in the charging system, the structure of the charging system is simplified, and assembly difficulty of the charging system is reduced.

In an implementation, the housing includes a second sidewall and a bottom wall. The second sidewall is connected to the first sidewall. The second sidewall and the first sidewall are disposed at an included angle. The bottom wall is connected to the first sidewall and the second sidewall, and is located at a bottom of the first sidewall and a bottom of the second sidewall. A projection of the DC input terminal on the second sidewall is a first projection. A projection of the DC output terminal on the second sidewall is a second projection. A projection of the DC input terminal on the bottom wall is a third projection. A projection of the DC output terminal on the bottom wall is a fourth projection. The first projection and the second projection at least partially overlap. The third projection and the fourth projection are staggered.

It may be understood that in one aspect, compared with a solution in which the first projection and the second projection are staggered, the first projection and the second projection at least partially overlap. In a direction perpendicular to the bottom wall, a thickness of an overlapping part may be reduced, so that a thickness of the DCDC module is smaller. In another aspect, the third projection and the fourth projection are staggered. In this way, the DC input terminal and the DC output terminal are disposed side by side, and are not stacked. This facilitates flat arrangement of the DCDC module. When the ACDC module is electrically connected to the DCDC module, or the two DCDC modules are electrically connected, there is no barrier between positions to be electrically connected. Therefore, the length of the conducting wire between the modules may be reduced, and the conducting wire is arranged more neatly.

In an implementation, a projection of the signal terminal on the second sidewall is a fifth projection. A projection of the signal terminal on the bottom wall is a sixth projection. The second projection and the fifth projection at least partially overlap. The fourth projection and the sixth projection are staggered.

It may be understood that the second projection and the fifth projection at least partially overlap, so that the thickness of the DCDC module may be further reduced.

In an implementation, the DCDC module includes a circuit board. The circuit board is disposed inside the housing. The DC input terminal, the DC output terminal, and the signal terminal are electrically connected to the circuit board.

The bottom wall includes a top surface and a bottom surface that are disposed back to each other. The bottom surface is a surface of a side that is of the bottom wall and that is away from the circuit board. A first groove is disposed on the bottom wall. An opening of the first groove is located on the bottom surface of the bottom wall. The housing further includes a second cover. The second cover is fastened to the bottom wall and covers the first groove. The second cover cooperates with the first groove to form a runner, and the runner is configured to circulate a coolant to cool the circuit board.

It may be understood that the runner may be configured to circulate the coolant. The coolant may be cooling water. The coolant is configured to take away heat when the circuit board works. Therefore, an objective of cooling is achieved and a fault of the circuit board caused by an excessively high operating temperature is avoided.

In addition, the runner through which the coolant flows is disposed on the bottom wall of the housing, and there is no need to additionally dispose a cooling plate used for liquid cooling. In this way, assembly difficulty of the DCDC module is reduced, an installation procedure is simplified, and product competitiveness is improved. The bottom wall of the housing has a function of a cooling plate. In addition, the housing may be further configured to load parts such as the circuit board, the DC input terminal, the DC output terminal, the signal terminal, and the like. The housing has a function of "one object for two purposes". In addition, because the coolant directly flows through the runner in the housing, there is no need to additionally design a pipe through which the coolant flows in the internal space of the housing. This helps reduce a size of the DCDC module.

In addition, the DCDC module applies a liquid cooling mode. Compared with an air cooling mode, the liquid cooling mode has a small noise, is not prone to dust accumulation, and does not have problems of salt spray corrosion and air channel blocking. The DCDC module is easy to maintain and has a long service life.

In an implementation, the housing includes a third sidewall. The first sidewall and the third sidewall are oppositely disposed spaced from each other. A second sidewall is connected between the first sidewall and the third sidewall. The bottom wall is connected to the first sidewall, the second sidewall, and the third sidewall, and is located at a bottom of the first sidewall, a bottom of the second sidewall, and a bottom of the third sidewall. A liquid inlet and a liquid outlet are disposed on the third sidewall. The liquid inlet and the liquid outlet are disposed spaced from each other. The liquid inlet communicates with the runner, and the liquid outlet communicates with the runner. The coolant can flow into the runner through the liquid inlet, flow to the liquid outlet through the runner, and flow out of the housing through the liquid outlet.

It may be understood that in this way, the liquid inlet and the liquid outlet are disposed opposite to the DC input terminal, the DC output terminal, and the signal terminal of the DCDC module. This can avoid to a maximum extent a problem of electric leakage caused by coolant leakage.

In an implementation, both the DC input terminal and the DC output terminal are of a floating structure.

It may be understood that the DC input terminal and the DC output terminal apply a floating structure, and when the DCDC module is installed, this facilitates quick implementations of blind insertion, quick connection, or quick separation between the DCDC module and various plugs. This reduces the risks of faults including shifting, skewness, misplacement, jamming, and the like during removal and insertion, and improves the reliability and service life of a device.

In an implementation, the DCDC module further includes a guide pin. The guide pin is connected to the first sidewall, and the guide pin is configured to assist in positioning the DCDC module in the charging system.

It may be understood that the guide pin is disposed, so that when the DCDC module is installed in the charging system, the guide pin may be configured to assist in positioning the DCDC module. This helps quickly install the DCDC module, implement precise positioning, reduce a risk of an installation error, and improve installation efficiency.

In an implementation, the DCDC module further includes a display component. The display component is connected to the third sidewall, and the display component is configured to display a current operating state of the DCDC module.

It may be understood that a user may analyze the current operating state of the DCDC module based on a prompt of the display component. When the DCDC module is faulty, the display component may help the user analyze a fault cause.

In an implementation, the DCDC module further includes a ground screw. The ground screw is located on the third sidewall, and the ground screw is used for grounding.

It may be understood that when the DCDC module is faulty and an electric leakage problem occurs, the ground screw may conduct a current to the ground. This reduces a risk of an accidental injury of a person.

In an implementation, the DCDC module includes a circuit board. The circuit board is disposed inside the housing. The DC input terminal, the DC output terminal, and the signal terminal are electrically connected to the circuit board.

When there is one circuit board, the circuit board is disposed parallel to the bottom wall.

When there are a plurality of circuit boards, the plurality of circuit boards are located on a same plane and are disposed parallel to the bottom wall.

It may be understood that the circuit board is disposed parallel to the bottom wall, and slight deviation is allowed. For example, the circuit board and the bottom wall may be disposed at an angle of 5 degrees, 10 degrees, or 15 degrees.

In an implementation, the housing includes a first nozzle and a second nozzle. The first nozzle is connected to an inner wall surface of the liquid inlet, and the second nozzle is connected to an inner wall surface of the liquid outlet.

It may be understood that the first nozzle and the second nozzle are configured to control a flow speed of the coolant in the runner.

In an implementation, the DCDC module further includes a handle. The handle is connected to the first sidewall, and the handle and the housing form an integrated structural component.

It may be understood that the handle may be configured to facilitate a user to capture the DCDC module. The handle and the housing form an integrated structural component. The handle is unlikely to be disconnected from the housing, and strength of the handle is higher.

In an implementation, the housing further includes side lugs. A quantity of the side lugs is two. The two side lugs are respectively located at two ends of the third sidewall. One side lug is connected to the second sidewall, and the other side lug is connected to the fourth sidewall.

It may be understood that the side lugs are configured to help fasten the DCDC module to an outer frame of the charging system.

In an implementation, a first holding groove is disposed on the second sidewall, and an opening of the first holding groove is located on the second sidewall and the bottom wall. A second holding groove is disposed on the fourth sidewall, and an opening of the second holding groove is located on the fourth sidewall and the bottom wall.

It may be understood that the first holding groove and the second holding groove may be used as lifting handles of the DCDC module. This facilitates grasping the ACDC module when the DCDC module is taken and placed. In addition, the first holding groove and the second holding groove are designed in a groove form. In this way, a width of a housing body is not increased, and it is avoided that the DCDC module occupies excessively large space in the charging system.

In an implementation, the housing further includes the fourth sidewall. The fourth sidewall and the second sidewall are oppositely disposed spaced from each other. The fourth sidewall is connected between the first sidewall and the third sidewall. The bottom wall is connected to the first sidewall, the second sidewall, the third sidewall, and the fourth sidewall, and is located at a bottom of the first sidewall, a bottom of the second sidewall, a bottom of the third sidewall, and a bottom of the fourth sidewall.

The housing includes a first cover. The first cover, the first sidewall, the second sidewall, the third sidewall, the fourth sidewall, and the bottom wall enclose an accommodation space, and the circuit board is disposed in the accommodation space.

It may be understood that the first cover, the first sidewall, the second sidewall, the third sidewall, the fourth sidewall, and the bottom wall enclose the accommodation space, and the circuit board is disposed in the accommodation space. The first cover, the first sidewall, the second sidewall, the third sidewall, the fourth sidewall, and the bottom wall may protect the circuit board to avoid impact of an external environment on the circuit board.

According to a third aspect, an embodiment of this application provides a charging module. The charging module includes a housing, an input terminal, an output terminal, and a signal terminal. The housing includes a first sidewall. A part of the input terminal, a part of the output terminal, and a part of the signal terminal are all located inside the housing. The other part of the input terminal, the other part of the output terminal, and the other part of the signal terminal all pass through the first sidewall and extend out of the housing. The input terminal, the output terminal, and the signal terminal are arranged in a length direction of the first sidewall.

It may be understood that the input terminal, the output terminal, and the signal terminal of the charging module are arranged in the length direction of the first sidewall. This facilitates flat arrangement of the charging module. When a conducting wire is arranged between a plurality of charging modules, the conducting wire does not need to bypass a structure such as the input terminal, the output terminal, or the signal terminal. Therefore, a length of the conducting wire may be reduced, and the conducting wire is arranged more neatly. When the charging module is used in the charging system, the structure of the charging system is simplified, and assembly difficulty of the charging system is reduced.

According to a fourth aspect, an embodiment of this application provides a charging system. The charging system includes an outer frame, an ACDC module, and a DCDC module. The ACDC module and the DCDC module are installed on the outer frame.

It may be understood that the outer frame is used as a bearing structure of the ACDC module and the DCDC module. Conducting wires of the ACDC module and the DCDC module are short in length, and the charging system has a simple structure and is less difficult to assemble.

In an implementation, the ACDC module and the DCDC module are arranged spaced from each other in a first direction, an AC input terminal and a DC output terminal of the ACDC module are arranged spaced from each other in a second direction, a DC input terminal and a DC output terminal of the DCDC module are arranged spaced from each other in the second direction, and the first direction and the second direction are disposed at an included angle.

The DC output terminal of the ACDC module and the DC input terminal of the DCDC module are oppositely disposed.

It may be understood that the DC output terminal of the ACDC module and the DC input terminal of the DCDC module in the charging system may be oppositely disposed. In this way, when a conducting wire is arranged to electrically connect the ACDC module and the DCDC module, there may be no barrier between the modules, and the conducting wire may not need to bypass a related structure. Therefore, a length of the conducting wire between the ACDC module and the DCDC module may be reduced. This helps simplify a structure of the charging system, and reduce assembly difficulty of the charging system.

### BRIEF DESCRIPTION OF DRAWINGS

To describe the technical solutions in embodiments of this application, the following describes the accompanying drawings used in describing embodiments of this application.
FIG. 1 is a schematic diagram of an implementation of an ACDC module according to this embodiment;
FIG. 2 is a schematic exploded view of a part of the ACDC module shown in FIG. 1;
FIG. 3 is a schematic diagram of a structure of the ACDC module shown in FIG. 1 from another perspective;
FIG. 4 is a schematic exploded view of a part of the ACDC module shown in FIG. 3;
FIG. 5 is a schematic diagram of an implementation of a DCDC module according to this embodiment;
FIG. 6 is a schematic exploded view of a part of the DCDC module shown in FIG. 5;
FIG. 7 is a schematic diagram of a structure of the DCDC module shown in FIG. 5 from another perspective;
FIG. 8 is a schematic exploded view of a part of the DCDC module shown in FIG. 7; and
FIG. 9 is a schematic diagram of an implementation of a charging system according to this embodiment.

### DESCRIPTION OF EMBODIMENTS

In the descriptions of embodiments of this application, it should be noted that unless otherwise specified and limited, the term "connection" should be understood in a broad sense. For example, the "connection" may be a detachable connection, or a non-removable connection, or may be a direct connection, or an indirect connection through an intermediate medium. The orientation terms mentioned in embodiments of this application, such as, "on" or "below", are merely directions with reference to the accompanying drawings. Therefore, the orientation terms are used to better and more clearly describe and understand embodiments of this application, but do not indicate or imply that a described apparatus or element needs to have a specific orientation or be constructed and operated in a specific orientation. Therefore, this shall not be understood as a limitation on embodiments of this application. In the following description, the terms such as "first" and "second" are merely intended for a purpose of description, and shall not be understood as indicating or implying relative importance or implying a quantity of indicated technical features. Therefore, a feature limited by "first" or "second" may explicitly or implicitly include one or more such features. In addition, a plurality of means at least two.

The following describes two charging modules with reference to the accompanying drawings in embodiments of this application. The two charging modules are an ACDC module 100 and a DCDC module 200. The ACDC module 100 is an alternating current and direct current module, and the DCDC module 200 is a direct current and direct current module. The ACDC module 100 and the DCDC module 200 may be used in a charging system. The charging system may be a charging pile of an electric vehicle, or may be an energy storage system.

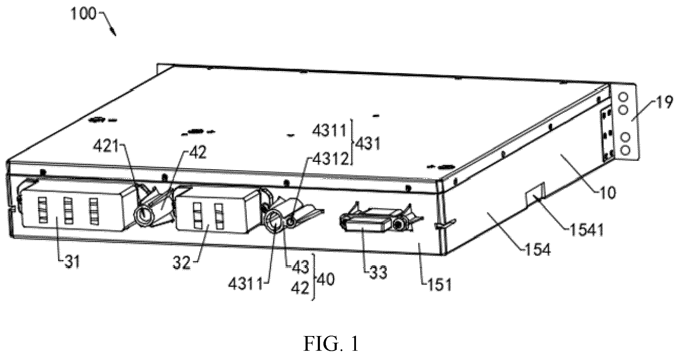

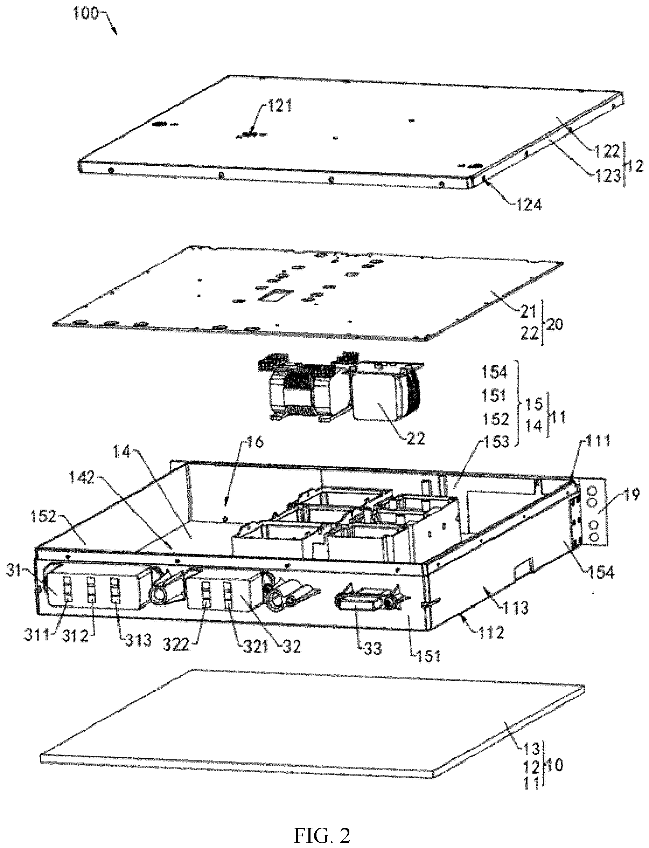

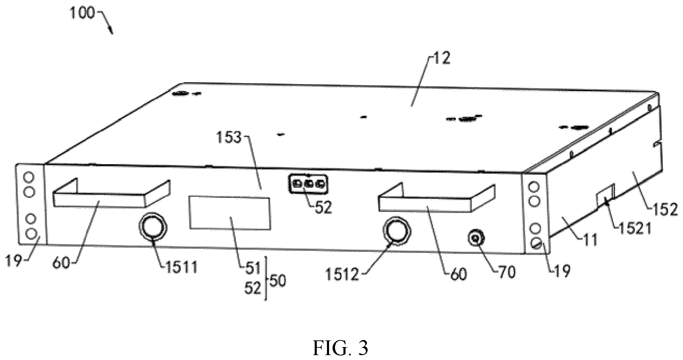

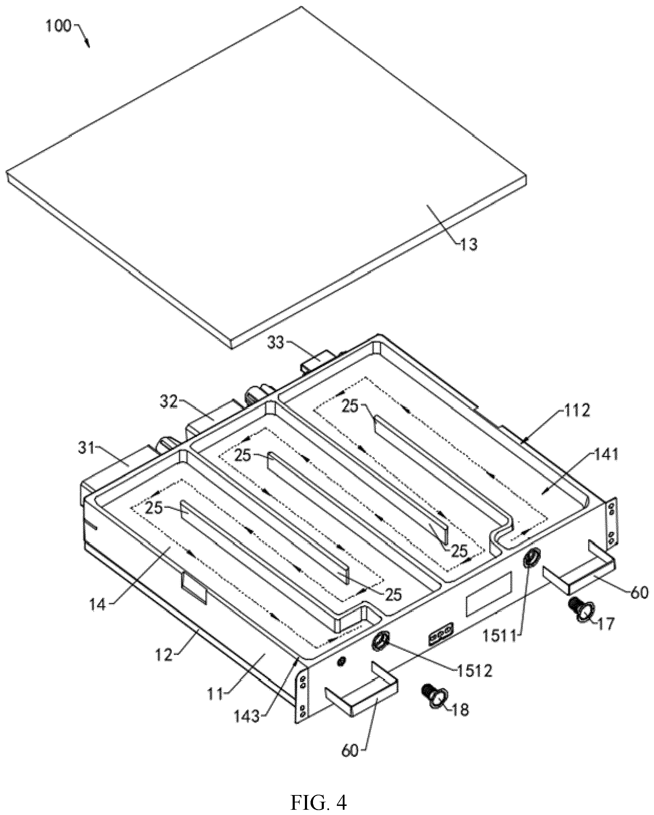

FIG. 1 is a schematic diagram of an implementation of the ACDC module 100 according to this embodiment. FIG. 2 is a schematic exploded view of a part of the ACDC module 100 shown in FIG. 1. FIG. 3 is a schematic diagram of a structure of the ACDC module 100 shown in FIG. 1 from another perspective. FIG. 4 is a schematic exploded view of a part of the ACDC module 100 shown in FIG. 3.

As shown in FIG. 1 to FIG. 4, the ACDC module 100 may include a housing 10, a circuit board assembly 20, an AC input terminal 31, a DC output terminal 32, a signal terminal 33, a guide pin 40, a display component 50, and a handle 60.

As shown in FIG. 2, the housing 10 may include a housing body 11, a first cover 12, and a second cover 13. The housing body 11 may include a top surface 111, a bottom surface 112, and a side surface 113. The top surface 111 and the bottom surface 112 are disposed back to each other, and the side surface 113 is connected to the top surface 111 and the bottom surface 112. The first cover 12 may be connected to the top surface 111. The second cover 13 may be connected to the bottom surface 112.

In some implementations, the housing body 11 may include a bottom wall 14 and a sidewall 15, and the sidewall 15 is connected to the bottom wall 14. The sidewall 15, the bottom wall 14, and the first cover 12 may jointly enclose an accommodation space 16.

In some implementations, the first cover 12 may not be disposed on the housing 10, and the sidewall 15 and the bottom wall 14 enclose the accommodation space 16. In some implementations, the second cover 13 may not be disposed on the housing 10. In some implementations, the bottom wall 14 may not be disposed on the housing 10.

In some implementations, the sidewall 15 may include a first sidewall 151, a second sidewall 152, a third sidewall 153, and a fourth sidewall 154. The first sidewall 151 and the third sidewall 153 are oppositely disposed spaced from each other, and the second sidewall 152 and the fourth sidewall 154 are oppositely disposed spaced from each other. The first sidewall 151 and the third sidewall 153 are connected between the second sidewall 152 and the fourth sidewall 154. The second sidewall 152 and the first sidewall 151 are disposed at an included angle. The first sidewall 151, the second sidewall 152, the third sidewall 153, and the fourth sidewall 154 are connected to the bottom wall 14, and the bottom wall 14 is located at a bottom of the first sidewall 151, a bottom of the second sidewall 152, a bottom of the third sidewall 153, and a bottom of the fourth sidewall 154. The first sidewall 151, the second sidewall 152, the third sidewall 153, the fourth sidewall 154, the bottom wall 14, and the first cover 12 enclose the accommodation space 16.

In some implementations, the first sidewall 151, the second sidewall 152, the third sidewall 153, the fourth sidewall 154, and the bottom wall 14 may be an integrally molded structure. In this way, strength of the housing body 11 is high. In another implementation, the bottom wall 14 may alternatively be fastened to the first sidewall 151, the second sidewall 152, the third sidewall 153, and the fourth sidewall 154 in a manner such as bonding, welding, or the like.

In some implementations, the second sidewall 152, the third sidewall 153, and the fourth sidewall 154 may not be disposed on the sidewall 15. In some implementations, the sidewall 15 may further include one or more of the second sidewall 152, the third sidewall 153, and the fourth sidewall 154. It may be understood that the second sidewall 152, the third sidewall 153, and the fourth sidewall 154 may be designed based on an actual requirement.

The circuit board assembly 20 may be disposed in the accommodation space 16. The circuit board assembly 20 may be configured to convert a three-phase alternating current into a direct current.

In some implementations, the circuit board assembly 20 may include a circuit board 21 and an electronic component 22. Both the circuit board 21 and the electronic component 22 may be disposed inside the housing 10. The electronic component 22 is disposed on a surface of a side that is of the circuit board 21 and that faces the bottom wall 14, and the circuit board 21 may be used as a carrier of the electronic component 22. For example, the electronic component 22 may be an active component such as a chip, or may be a passive component such as a capacitor, an inductor, a resistor, or the like. A person skilled in the art can select a type and a quantity of the electronic component 22 based on an actual requirement. This is not limited in this application.

There may be one or more circuit boards 21 of the circuit board assembly 20.

In some implementations, there is one the circuit board 21, and the circuit board 21 is disposed parallel to the bottom wall 14. It may be understood that the circuit board 21 is disposed parallel to the bottom wall 14, and slight deviation is allowed. For example, the circuit board 21 and the bottom wall 14 may be disposed at an angle of 5 degrees, 10 degrees, or 15 degrees.

In some implementations, there are a plurality of circuit boards 21, and the plurality of circuit boards 21 may be located on a same plane and disposed parallel to the bottom wall 14. The plane on which the plurality of circuit boards 21 are located is parallel to the bottom wall 14, and slight deviation is allowed. For example, the plane and the bottom wall 14 may be disposed at an angle of 5 degrees, 10 degrees, or 15 degrees.

In some implementations, in a direction perpendicular to the bottom wall 14, distances from the plurality of circuit boards 21 to the bottom wall 14 of the housing body 11 may be equal (slight deviation is allowed).

In some implementations, the circuit board 21 is connected to the first cover 12. The first cover 12 is located on a side that is of the circuit board 21 and that is away from the bottom wall 14 of the housing body 11. For example, the first cover 12 includes a bottom board 122 and a side board 123. A first through hole 121 may be disposed in the bottom board 122 of the first cover 12. The first through hole 121 may be configured to provide a channel through which a screw passes, and the screw may be configured to connect the circuit board 21 of the circuit board assembly 20 and the first cover 12. Therefore, the circuit board assembly 20 is fastened to the first cover 12. In another implementation, the circuit board 21 may alternatively be connected to the first cover 12 in a manner of adhesive bonding or welding.

In some implementations, the first cover 12 may be connected to the housing body 11. The first cover 12 may be configured to protect the circuit board assembly 20, to avoid interference when the circuit board assembly 20 works.

In some implementations, a second through hole 124 may be disposed in the side board 123. The second through hole 124 may be configured to provide a channel through which a screw passes, and to fasten the first cover 12 to the housing body 11. The first cover 12 may be connected to the housing body 11 through the side board 123. In another implementation, the first cover 12 may be connected to the housing body 11 in a manner such as welding, adhesive bonding, or the like.

In some implementations, a screw hole for positioning may be further disposed in the first cover 12.

As shown in FIG. 1 and FIG. 2, the AC input terminal 31, the DC output terminal 32, and the signal terminal 33 may be connected to the housing body 11. For example, the AC input terminal 31, the DC output terminal 32, and the signal terminal 33 are all fastened to the first sidewall 151 of the housing body 11. In this way, it is convenient for a user to remove and insert a current cable and a signal cable during connection.

For example, a part of the AC input terminal 31, a part of the DC output terminal 32, and a part of the signal terminal 33 may all be located inside the housing 10. The other part of the AC input terminal 31, the other part of the DC output terminal 32, and the other part of the signal terminal 33 may all pass through the first sidewall 151 and extend out of the housing 10. The AC input terminal 31, the DC output terminal 32, and the signal terminal 33 are arranged in a length direction of the first sidewall 151.

It may be understood that the AC input terminal 31, the DC output terminal 32, and the signal terminal 33 of the ACDC module 100 are arranged on the first sidewall 151 in the length direction of the first sidewall 151. This facilitates flat arrangement of the ACDC module 100. When a conducting wire is arranged between a plurality of ACDC modules 100, the conducting wire does not need to bypass a structure such as the AC input terminal 31, the DC output terminal 32, or the signal terminal 33. Therefore, a length of the conducting wire may be reduced, and the conducting wire is arranged more neatly. When the ACDC module 100 is used in a charging system, a structure of the charging system is simplified, and assembly difficulty of the charging system is reduced.

The AC input terminal 31, the DC output terminal 32, and the signal terminal 33 may be electrically connected to the circuit board assembly 20 through conducting wires. The AC input terminal 31, the DC output terminal 32, and the signal terminal 33 may be used as connectors for connecting an external plug to the circuit board assembly 20. In some implementations, the AC input terminal 31, the DC output terminal 32, and the signal terminal 33 may be electrically connected to the circuit board 21 through conducting wires.

The AC input terminal 31 may be connected to a three-phase alternating current, and is electrically connected to the circuit board assembly 20. The DC output terminal 32 may be connected to the circuit board assembly 20 and the DCDC module 200. In this way, when the ACDC module 100 works, the three-phase alternating current can flow into the circuit board assembly 20 through the AC input terminal 31. After the circuit board assembly 20 converts the three-phase alternating current into a direct current, the direct current flows out to the DCDC module 200 through the DC output terminal 32. The signal terminal 33 may be used for communication between the ACDC module 100 and another module in the charging system. The signal terminal 33 may be electrically connected to the circuit board assembly 20 and a control circuit of the charging system.

As shown in FIG. 2, the AC input terminal 31 may include a first phase current input port 311, a second phase current input port 312, and a third phase current input port 313 that are disposed spaced from one another. The first phase current input port 311, the second phase current input port 312, and the third phase current input port 313 are arranged in the length direction of the first sidewall 151.

It may be understood that compared with a solution in which the first phase current input port 311, the second phase current input port 312, and the third phase current input port 313 are arranged in a height direction of the first sidewall 151 (that is, a thickness direction of the ACDC module 100), the first phase current input port 311, the second phase current input port 312, and the third phase current input port 313 are arranged in the length direction of the first sidewall 151. When the conducting wire is arranged between AC input terminals 31 of the plurality of ACDC modules, there may be no barrier between input ports to be electrically connected. Therefore, the length of the conducting wire may be reduced, and the conducting wire is arranged more neatly. When the ACDC module 100 is used in the charging system, the structure of the charging system is simplified, and assembly difficulty of the charging system is reduced.

In some implementations, the DC output terminal 32 may include a positive output port 321 and a negative output port 322 that are disposed spaced from each other, and the positive output port 321 and the negative output port 322 are arranged in the length direction of the first sidewall 151.

It may be understood that compared with a solution in which the positive output port 321 and the negative output port 322 of the DC output terminal 32 are arranged in the height direction of the first sidewall 151 (that is, the thickness direction of the ACDC module 100), the positive output port 321 and the negative output port 322 are arranged in the length direction of the first sidewall 151. When a conducting wire is arranged between DC output terminals 32 of the plurality of ACDC modules, there is no barrier between ports to be electrically connected and the conducting wire does not need to bypass some structures on the first sidewall 151. Therefore, the length of the conducting wire may be reduced, and the conducting wire is arranged more neatly. When the ACDC module 100 is used in the charging system, the structure of the charging system is simplified, and assembly difficulty of the charging system is reduced.

In some implementations, the DC output terminal 32 is located between the AC input terminal 31 and the signal terminal 33, and the AC input terminal 31 is located on a side that is of the DC output terminal 32 and that is close to the second sidewall 152.

It may be understood that the AC input terminal 31 is located on one side of the DC output terminal 32, and a three-phase alternating current may be accessed from the outside from the AC input terminal 31 side. In this way, the conducting wire does not need to bypass the DC output terminal 32 or the signal terminal 33. Therefore, the length of the conducting wire may be reduced, and the conducting wire is arranged more neatly. When the ACDC module 100 is used in the charging system, the structure of the charging system is simplified, and assembly difficulty of the charging system is reduced.

In some implementations, a projection of the AC input terminal 31 on the second sidewall 152 is a first projection. A projection of the DC output terminal 32 on the second sidewall 152 is a second projection. A projection of the AC input terminal 31 on the bottom wall 14 is a third projection. A projection of the DC output terminal 32 on the bottom wall 14 is a fourth projection. The first projection and the second projection at least partially overlap, and the third projection and the fourth projection are staggered. In other words, the third projection and the fourth projection are disposed spaced from each other on the bottom wall 14.

It may be understood that in one aspect, compared with a solution in which the first projection and the second projection are staggered, the first projection and the second projection at least partially overlap. In a direction perpendicular to the bottom wall 14, a thickness of an overlapping part may be reduced, so that a thickness of the ACDC module 100 is smaller. In another aspect, the third projection and the fourth projection are staggered. In this way, the AC input terminal 31 and the DC output terminal 32 are disposed side by side, and are not stacked. This facilitates flat arrangement of the ACDC module 100. When the ACDC module 100 is electrically connected to the DCDC module 200, or the two ACDC modules 100 are electrically connected, there is no barrier between positions that need to be electrically connected. Therefore, the length of the conducting wire may be reduced, and the conducting wire is arranged more neatly.

In some implementations, a projection of the signal terminal 33 on the second sidewall 152 is a fifth projection, and a projection of the signal terminal 33 on the bottom wall 14 is a sixth projection. The second projection and the fifth projection at least partially overlap, and the fourth projection and the sixth projection are staggered. In this way, a thickness of the ACDC module 100 may be further reduced.

In some implementations, the AC input terminal 31, the DC output terminal 32, and the signal terminal 33 are all of a floating structure. The floating structure means that metal terminals inside the AC input terminal 31, the DC output terminal 32, and the signal terminal 33 may move in a specific range upward, downward, leftward, and rightward. The AC input terminal 31 is used as an example. The AC input terminal 31 includes a shell and a metal terminal located inside the shell. The metal terminal may be configured to electrically connect the outside to the circuit board assembly 20 of the ACDC module 100. The shell is fastened to the first sidewall 151 of the housing body 11, and the metal terminal may move relative to the first sidewall 151 in a specific range upward, downward, leftward, and rightward.

It may be understood that the AC input terminal 31, the DC output terminal 32, and the signal terminal 33 apply a floating structure, and when the ACDC module 100 is installed, this facilitates quick implementations of blind insertion, quick connection, or quick separation between the ACDC module 100 and various plugs. This reduces the risks of faults including shifting, skewness, misplacement, jamming, and the like during removal and insertion, and improves the reliability and service life of a device.

As shown in FIG. 2 again, the guide pin 40 may be connected to the sidewall 15 of the housing body 11. The guide pin 40 may be configured to assist in positioning the ACDC module 100 in the charging system.

In some implementations, the guide pin 40 may be connected to the first sidewall 151 of the housing body 11. The guide pin 40, the AC input terminal 31, the DC output terminal 32, and the signal terminal 33 may all be disposed on the first sidewall 151. In this way, a structural device layout on the first sidewall 151 of the ACDC module 100 is compact.

In some implementations, a limiting hole may be disposed in the guide pin 40. A bump (not shown in the figure) may be disposed on the charging system. A shape of the bump matches a shape of the limiting hole.

It may be understood that the guide pin 40 may form a concave-convex structure together with the charging system to implement positioning. The limiting hole in the guide pin 40 is used as a "concave" part, and the bump on the outer frame 300 is used as a "convex" part. Shapes of the limiting hole and the bump match each other to help position the ACDC module 100. In another implementation, the guide pin 40 may not be provided with the limiting hole, but is used as a "convex" part and cooperates with a "concave" part on the outer frame 300 to implement a positioning function.

In some implementations, the limiting hole in the guide pin 40 and the bump on the outer frame 300 may be set to a specific shape. Therefore, the ACDC module 100 may be distinguished from another module included in a charging system 1000. When the ACDC module 100 is installed, whether the ACDC module 100 is correctly installed may be determined by determining whether the limiting hole matches the bump. Therefore, installation efficiency is improved.

There may be one or more guide pins 40. For example, there are two guide pins 40: a first guide pin 42 and a second guide pin 43. A first limiting hole 421 may be disposed in the first guide pin 42, and a second limiting hole 431 may be disposed in the second guide pin 43. The first guide pin 42 is located between the AC input terminal 31 and the DC output terminal 32. The second guide pin 43 is located between the DC output terminal 32 and the signal terminal 33.

In some implementations, the second limiting hole 431 includes a first part 4311 and a second part 4312. A shape of the first limiting hole 421 may be different from a shape of the second limiting hole 431. A first bump (not shown in the figure) and a second bump (not shown in the figure) may be disposed on the charging system. A shape of the first bump matches a shape of the first limiting hole 421, and a shape of the second bump matches a shape of the second limiting hole 431. It may be understood that two limiting holes of different shapes are disposed in the ACDC module 100. In this way, an offset position of the module in an installation process may be restricted based on positions of the two limiting holes relative to the charging system. This can help insert the ACDC module 100 into the charging system in a blind manner. Therefore, installation efficiency of the ACDC module 100 is improved. In another implementation, a shape of the first limiting hole 421 may alternatively be the same as a shape of the second limiting hole 431.

It may be understood that the guide pin 40 is disposed, so that when the ACDC module 100 is installed in the charging system, the guide pin 40 may be configured to assist in positioning the ACDC module 100. This helps quickly install the ACDC module 100, implement precise positioning, reduce a risk of an installation error, and improve installation efficiency.

In another implementation, the guide pin 40 may alternatively be fastened to the second sidewall 152, the third sidewall 153, or the fourth sidewall 154 of the housing body 11.

In another implementation, the ACDC module 100 may not include the guide pin 40.

As shown in FIG. 4, a first groove 141 may be disposed on the bottom wall 14 of the housing body 11. The bottom wall 14 includes a top surface 142 and a bottom surface 143 that are disposed back to each other, and the bottom surface 143 is a surface of a side that is of the bottom wall 14 and that is away from the circuit board 21. An opening of the first groove 141 is located on the bottom surface 143 of the bottom wall 14. The second cover 13 is fastened to the bottom wall 14, and covers the first groove 141. The second cover 13 may be configured to cooperate with the first groove 141 to form a runner, and the runner may be configured to circulate a coolant to cool the circuit board 21 and the electronic component 22. The bottom surface 143 of the bottom wall 14 is also the bottom surface 112 of the housing body 11.

It may be understood that the runner may be configured to circulate the coolant. The coolant may be cooling water. The coolant is configured to take away heat of a circuit when the circuit board assembly 20 works. Therefore, an objective of cooling is achieved and a fault of the circuit board assembly 20 caused by an excessively high operating temperature is avoided.

In addition, the runner through which the coolant flows is disposed on the bottom wall 14 of the housing body 11, and there is no need to additionally dispose a cooling plate used for liquid cooling. In this way, assembly difficulty of the ACDC module is reduced, an installation procedure is simplified, and product competitiveness is improved. The bottom wall 14 of the housing body 11 has a function of a cooling plate. In addition, the housing body 11 may be further configured to load parts such as the circuit board assembly 20, the AC input terminal 31, the DC output terminal 32, the signal terminal 33, and the like. The housing body 11 has a function of "one object for two purposes". In addition, because the coolant directly flows through the runner in the housing body 11, there is no need to additionally design a pipe through which the coolant flows in the accommodation space 16. This helps reduce a size of the ACDC module 100.

In addition, the ACDC module 100 applies a liquid cooling mode. Compared with an air cooling mode, the liquid cooling mode has a small noise, is not prone to dust accumulation, and does not have problems of salt spray corrosion and air channel blocking. The ACDC module 100 is easy to maintain and has a long service life.

In some implementations, the second cover 13 may be fastened to the bottom surface 143 of the bottom wall 14 in a manner of welding. Therefore, the runner may be sealed. In another implementation, the second cover 13 may alternatively be fastened to the bottom surface 143 of the bottom wall 14 in a manner of adhesive bonding.

In some implementations, a liquid inlet 1511 and a liquid outlet 1512 are disposed spaced from each other on the third sidewall 153 of the housing body 11. It may be understood that in this way, the liquid inlet 1511 and the liquid outlet 1512 are disposed opposite to the AC input terminal 31, the DC output terminal 32, and the signal terminal 33 of the ACDC module 100. This can avoid to a maximum extent a problem of electric leakage caused by coolant leakage.

The liquid inlet 1511 may communicate with the runner. The liquid outlet 1512 may also communicate with the runner. In this way, the coolant can flow into the runner through the liquid inlet 1511, flow to the liquid outlet 1512 through the runner, and flow out of the housing body 11 through the liquid outlet 1512. FIG. 4 schematically shows a flow path of the coolant in the runner by using a dashed line and arrows.

In another implementation, the liquid inlet 1511 and the liquid outlet 1512 may alternatively be located at another position on the side surface 113 of the bottom wall 14, for example, the second sidewall 152.

In some implementations, the housing body 11 further includes a baffle bar 25. The baffle bar 25 is connected to the bottom wall 14 and the second cover 13. The baffle bar 25 may be configured to cooperate with the housing body 11 and the second cover 13 to separate the runner to form a specific shape. Therefore, the coolant flows in a specific direction in the runner. For example, there are five baffle bars 25, and a continuous "S"-shaped runner is formed. In this way, the coolant can flow along the "S"-shaped runner. In this way, a flow path of the coolant in the runner may be prolonged, heat exchange time is prolonged, and cooling efficiency is improved.

In some implementations, the housing 10 may further include a first nozzle 17 and a second nozzle 18. The first nozzle 17 is connected to an inner wall surface of the liquid inlet 1511 in the housing body 11. The second nozzle 18 is connected to an inner wall surface of the liquid outlet 1512 in the housing body 11. The first nozzle 17 and the second nozzle 18 may be configured to control a flow speed of the coolant in the runner.

In some implementations, threads may be disposed on inner wall surfaces of the liquid inlet 1511 and the liquid outlet 1512, and threads matching the threads on the inner wall surfaces of the liquid inlet 1511 and the liquid outlet 1512 may also be disposed on surfaces of the first nozzle 17 and the second nozzle 18. In this way, the first nozzle 17 and the second nozzle 18 may be more closely connected to the housing body 11 through screw-thread fit.

In some implementations, the housing 10 may further include a first sealing ring (not shown in the figure) and a second sealing ring (not shown in the figure). The first sealing ring is located between the first nozzle 17 and the housing body 11. The second sealing ring is located between the second nozzle 18 and the housing body 11. It may be understood that the first sealing ring may cooperate with the first nozzle 17, and may be configured to implement close connection between the first nozzle 17 and the housing body 11, to reduce a risk that the coolant leaks from a gap between the first nozzle 17 and the housing body 11. The second sealing ring may cooperate with the second nozzle 18, and may be configured to implement close connection between the second nozzle 18 and the housing body 11, to reduce a risk that the coolant leaks from a gap between the second nozzle 18 and the housing body 11.

The first sealing ring and the second sealing ring may be made of rubber, or the like.

As shown in FIG. 3 and FIG. 4, the display component 50 may be disposed on a third sidewall 153 of the housing body 11, and the display component 50, the liquid inlet 1511, and the liquid outlet 1512 are located on a same sidewall (the third sidewall 153). In this way, components on the housing body 11 of the ACDC module 100 are arranged more compactly. The display component 50 is configured to display a current operating state of the ACDC module 100.

The display component 50 may be a display panel, and may be configured to display a related parameter of the ACDC module 100, or may be a display light, and indicate a state of the ACDC module 100 by using lights of different colors.

In some implementations, the display component 50 may include a display panel 51 and a display light 52. In this way, the user may quickly determine a state of the ACDC module based on the color of the display light 52, and may analyze a state of the ACDC module 100 based on a parameter prompt displayed on the display panel 51. In addition, when the ACDC module 100 is faulty, a parameter displayed on the display panel 51 may assist the user in analyzing a fault cause.

In another implementation, the display component 50 may alternatively be disposed on the second sidewall 152 or the fourth sidewall 154 of the housing body 11.

In some implementations, the display component 50 may not be disposed on the ACDC module 100.

As shown in FIG. 3 again, the handle 60 may be disposed on the third sidewall 153 of the housing body 11. The handle 60, the liquid inlet 1511, the liquid outlet 1512, and the display component 50 are all located on the third sidewall 153. In this way, components on the housing body 11 of the ACDC module 100 are arranged more compactly. It may be understood that the handle 60 may be configured to facilitate a user to capture the ACDC module 100.

There may be one or more handles 60. In some implementations, there are two handles 60 that are respectively disposed at two ends of the third sidewall 153.

In some implementations, the handle 60 and the housing body 11 may form an integrated structural part in a manner such as die casting or welding, and the handle is unlikely to be disconnected from the housing. It may be understood that, that two parts are integrally molded into an integrated structural component means that in a process of forming one part of the two parts, the part is connected to the other part, and the two parts do not need to be connected together in a manner of reprocessing (for example, bonding, welding, fastener connection, or screw connection).

In another implementation, the handle 60 may alternatively be connected to the housing body 11 in a manner such as bonding, buckle connection, screw connection, or the like.

In some implementations, the handle 60 may not be disposed on the ACDC module 100.

As shown in FIG. 3 again, the housing 10 further includes side lugs 19. There are two side lugs 19. One side lug 19 is located at one end that is of the third sidewall 153 and that is close to the second sidewall 152, and the other side lug 19 is located at one end that is of the third sidewall 153 and that is close to the fourth sidewall 154. It may be understood that the side lugs 19 are configured to help fasten the ACDC module 100 to the outer frame of the charging system. For example, a through hole may be disposed on the side lug 19, and the through hole is configured to allow a screw or a fastener to pass through, to install the ACDC module 100 in the charging system.

As shown in FIG. 2 and FIG. 3, the two side lugs 19 may be respectively fastened to the second sidewall 152 and the fourth sidewall 154 through screws.

In some implementations, the side lug 19 may not be disposed on the ACDC module 100.

As shown in FIG. 1 and FIG. 3 again, a first holding groove 1521 may be disposed on the second sidewall 152 of the housing body 11, and a second holding groove 1541 may be disposed on the fourth sidewall 154.

An opening of the first holding groove 1521 is located on the second sidewall 152 and the bottom wall 14 of the housing body 11, and an opening of the second holding groove 1541 is located on the fourth sidewall 154 and the bottom wall 14 of the housing body 11. It may be understood that the first holding groove 1521 and the second holding groove 1541 are disposed, so that the ACDC module 100 may be easily captured when the ACDC module is taken and placed. In addition, the first holding groove 1521 and the second holding groove 1541 are designed in a groove form. In this way, a width of the housing body 11 is not increased, and it is avoided that the ACDC module 100 occupies space in the charging system 1000.

As shown in FIG. 3 again, the ACDC module 100 may further include a ground screw 70. The ground screw 70 is electrically connected to the circuit board assembly 20. The ground screw 70 is configured to be connected to a ground cable, to avoid that an electric leakage problem occurs when the ACDC module 100 is faulty and causes an accidental injury of a person. In an implementation, the ground screw 70 may be disposed on the third sidewall 153 of the housing body 11. In another implementation, the ground screw may alternatively be disposed on the first sidewall 151, the second sidewall 152, or the fourth sidewall 154 of the housing body 11.

In some implementations, the ACDC module 100 may further include a waterproof film (not shown in the figure). The waterproof film covers a surface that is of the first cover 12 and that is away from the accommodation space 16. The waterproof film may cover a gap on the first cover 12, to avoid that external water vapor enters the accommodation space 16 inside the ACDC module and causes a fault of the circuit board assembly 20.

It may be understood that the ACDC module 100 in this application includes the housing 10, the AC input terminal 31, the DC output terminal 32, and the signal terminal 33. The housing 10 includes the first sidewall 151. A part of the AC input terminal 31, a part of the DC output terminal 32, and a part of the signal terminal 33 are all located inside the housing 10. The other part of the AC input terminal 31, the other part of the DC output terminal 32, and the other part of the signal terminal 33 all pass through the first sidewall 151 and extend out of the housing 10. The AC input terminal 31, the DC output terminal 32, and the signal terminal 33 are arranged in the length direction of the first sidewall 151.

It may be understood that the AC input terminal 31, the DC output terminal 32, and the signal terminal 33 of the ACDC module are arranged on the first sidewall 151 in the length direction of the first sidewall. This facilitates flat arrangement of the ACDC module 100. When a conducting wire is arranged between a plurality of ACDC modules 100, the conducting wire does not need to bypass a structure such as the AC input terminal 31, the DC output terminal 32, or the signal terminal 33. Therefore, a length of the conducting wire may be reduced, and the conducting wire is arranged more neatly. When the ACDC module 100 is used in the charging system, the structure of the charging system is simplified, and assembly difficulty of the charging system is reduced.

The foregoing specifically describes several implementations of the ACDC module 100 with reference to related accompanying drawings. The following describes several implementations of the DCDC module 200 with reference to related accompanying drawings.

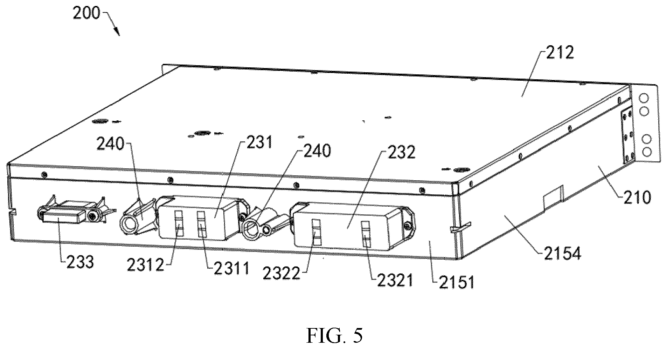

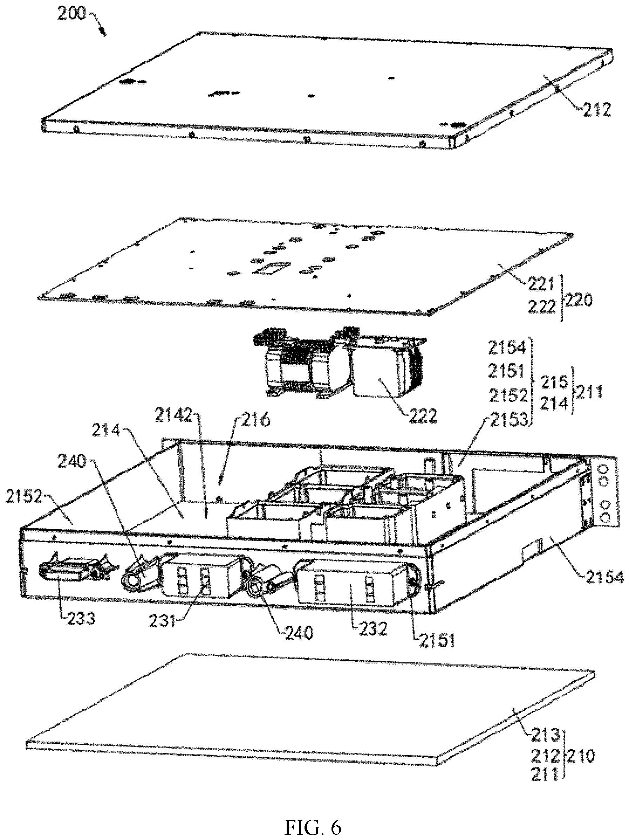

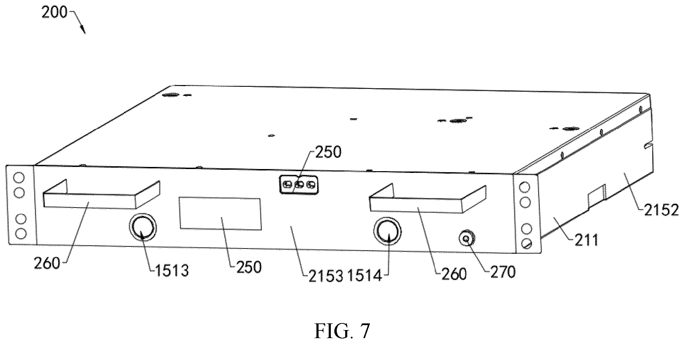

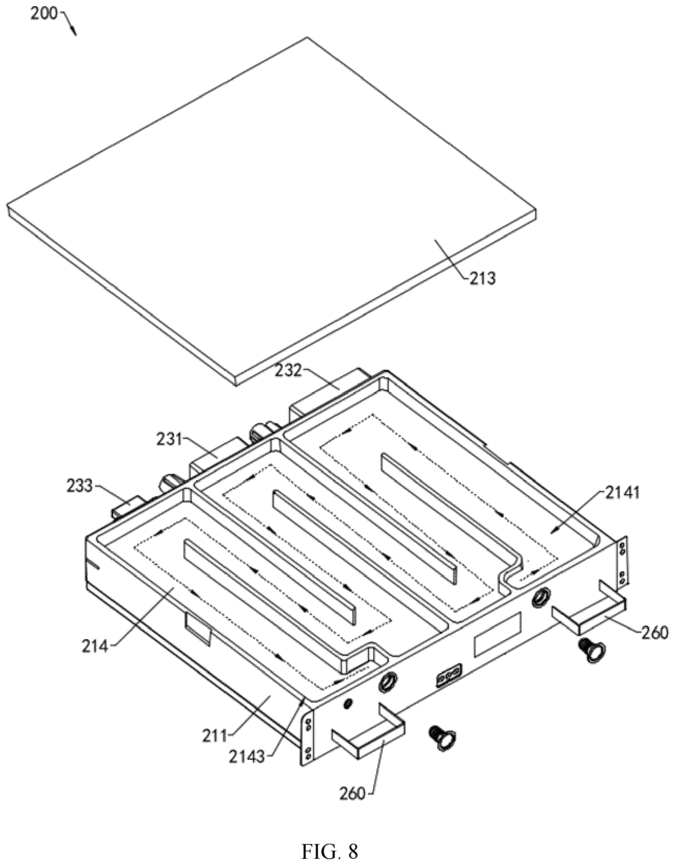

FIG. 5 is a schematic diagram of an implementation of the DCDC module 200 according to this embodiment. FIG. 6 is a schematic exploded view of a part of the DCDC module 200 shown in FIG. 5. FIG. 7 is a schematic diagram of a structure of the DCDC module 200 shown in FIG. 5 from another perspective. FIG. 8 is a schematic exploded view of a part of the DCDC module 200 shown in FIG. 7.

As shown in FIG. 5 to FIG. 6, the DCDC module 200 may include a housing 210, a circuit board assembly 220, a DC input terminal 231, a DC output terminal 232, and a signal terminal 233. For a manner of disposing the housing 210 and the circuit board assembly 220 of the DCDC module 200, refer to a manner of disposing the housing 10 and the circuit board assembly 20 of the ACDC module 100.

The housing 210 of the DCDC module 200 may include a housing body 211, a first cover 212, and a second cover 213. The housing body 211 may include a bottom wall 214 and a sidewall 215. The sidewall 215, the bottom wall 214, and the first cover 212 may jointly enclose an accommodation space 216.

As shown in FIG. 7, the sidewall 215 includes a first sidewall 2151, a second sidewall 2152, a third sidewall 2153, and a fourth sidewall 2154. The first sidewall 2151 and the third sidewall 2153 are oppositely disposed spaced from each other, and the second sidewall 2152 and the fourth sidewall 2154 are oppositely disposed spaced from each other. The second sidewall 2152 and the first sidewall 2151 are disposed at an included angle. The first sidewall 2151 and the third sidewall 2153 are connected between the second sidewall 2152 and the fourth sidewall 2154. The first sidewall 2151, the second sidewall 2152, the third sidewall 2153, and the fourth sidewall 2154 are connected to the bottom wall 214, and the bottom wall 214 is located at a bottom of the first sidewall 2151, a bottom of the second sidewall 2152, a bottom of the third sidewall 2153, and a bottom of the fourth sidewall 2154. The first sidewall 2151, the second sidewall 2152, the third sidewall 2153, the fourth sidewall 2154, the bottom wall 214, and the first cover 212 enclose the accommodation space 216.

The circuit board assembly 220 may be disposed in the accommodation space 216. The circuit board assembly 220 may be configured to convert a power of a direct current. For example, the circuit board assembly 220 may convert a high-voltage direct current into a low-voltage direct current, or convert a low-voltage direct current into a high-voltage direct current.

In some implementations, the circuit board assembly 220 may include a circuit board 221 and an electronic component 222. Both the circuit board 221 and the electronic component 222 may be disposed inside the housing 210.

There may be one or more circuit boards 221 of the circuit board assembly 220.

In some implementations, there may be one circuit board 221, and the circuit board 221 is disposed parallel to the bottom wall 214. It may be understood that the circuit board 221 is disposed parallel to the bottom wall 214, and slight deviation is allowed. For example, the circuit board 221 and the bottom wall 214 may be disposed at an angle of 5 degrees, 10 degrees, or 15 degrees.

In some implementations, there are a plurality of circuit boards 221, and the plurality of circuit boards 221 may be located on a same plane and disposed parallel to the bottom wall 214. The plane on which the plurality of circuit boards 221 are located is parallel to the bottom wall 214, and slight deviation is allowed. For example, the plane and the bottom wall 214 may be disposed at an angle of 5 degrees, 10 degrees, or 15 degrees.

In some implementations, in a direction perpendicular to the bottom wall 214, distances from the plurality of circuit boards 221 to the bottom wall 214 of the housing body 211 may be equal (slight deviation is allowed).

For a connection manner of the first cover 212, the circuit board 221, and the housing body 211 of the DCDC module 200, refer to a connection manner of the first cover 12, the circuit board 21, and the housing body 11 of the ACDC module 100.

In some implementations, the DC input terminal 231, the DC output terminal 232, and the signal terminal 233 may be connected to the housing body 211. For example, the DC input terminal 231, the DC output terminal 232, and the signal terminal 233 are all fastened to the first sidewall 2151 of the housing body 211. In this way, it is convenient for a user to remove and insert a current cable and a signal cable during connection.

For example, a part of the DC input terminal 231, a part of the DC output terminal 232, and a part of the signal terminal 233 are all located inside the housing 210, the other part of the DC input terminal 231, the other part of the DC output terminal 232, and the other part of the signal terminal 233 all pass through the first sidewall 2151 and extend out of the housing 210, and the DC input terminal 231, the DC output terminal 232, and the signal terminal 233 are arranged in a length direction of the first sidewall 2151.

It may be understood that the DC input terminal 231, the DC output terminal 232, and the signal terminal 233 of the DCDC module 200 are arranged in the length direction of the first sidewall 2151. This facilitates flat arrangement of the DCDC module 200. When a conducting wire is arranged between a plurality of DCDC modules 200, the conducting wire does not need to bypass a structure such as the DC input terminal 231, the DC output terminal 232, or the signal terminal 233. Therefore, a length of the conducting wire may be reduced, and the conducting wire is arranged more neatly. When the DCDC module 200 is used in a charging system, a structure of the charging system is simplified, and assembly difficulty of the charging system is reduced.

The DC input terminal 231, the DC output terminal 232, and the signal terminal 233 may be electrically connected to the circuit board assembly 220 through conducting wires. The DC input terminal 231, the DC output terminal 232, and the signal terminal 233 may be used as connectors for connecting the circuit board assembly 220. In some implementations, the DC input terminal 231, the DC output terminal 232, and the signal terminal 233 may be electrically connected to the circuit board 221 through conducting wires.

The DC input terminal 231 may be electrically connected to the ACDC module 100 and the circuit board assembly 220. The DC output terminal 232 may be electrically connected to the circuit board assembly 220 and a to-be-charged device. In this way, when the DCDC module 200 works, a direct current output by the ACDC module 100 can flow into the circuit board assembly 220 through the DC input terminal 231. The circuit board assembly 220 may convert the direct current output by the ACDC module 100 into a direct current suitable for a voltage of the to-be-charged device. The direct current flows out through the DC output terminal 232, and finally is input to the to-be-charged device. The signal terminal 233 may be used for communication between the DCDC module 200 and another module in the charging system. The signal terminal 233 may be electrically connected to the circuit board assembly 220 and a control circuit of the charging system.

As shown in FIG. 5, the DC input terminal 231 includes a positive input port 2311 and a negative input port 2312 that are disposed spaced from each other, and the positive input port 2311 and the negative input port 2312 are arranged in the length direction of the first sidewall 2151.

It may be understood that compared with a solution in which the positive input port 2311 and the negative input port 2312 of the DC input terminal 231 are arranged in a height direction of the first sidewall 2151 (that is, a thickness direction of the DCDC module 200), the positive input port 2311 and the negative input port 2312 of the DC input terminal 231 are arranged in the length direction of the first sidewall 2151. When the conducting wire is arranged between DC input terminals 231 of the plurality of DCDC modules 200, there may be no barrier between ports to be electrically connected. Therefore, the length of the conducting wire may be reduced, and the conducting wire is arranged more neatly. When the DCDC module 200 is used in the charging system, the structure of the charging system is simplified, and assembly difficulty of the charging system is reduced.

In some implementations, the DC output terminal 232 includes a positive output port 2321 and a negative output port 2322 that are disposed spaced from each other, and the positive output port 2321 and the negative output port 2322 are arranged in the length direction of the first sidewall 2151.

It may be understood that compared with a solution in which the positive output port 2321 and the negative output port 2322 of the DC output terminal 232 are arranged in the height direction of the first sidewall 2151 (that is, the thickness direction of the DCDC module 200), the positive output port 2321 and the negative output port 2322 are arranged in the length direction of the first sidewall 2151. When the conducting wire is arranged between DC output terminals 232 of the plurality of DCDC modules 200, there may be no barrier between ports to be electrically connected. Therefore, the length of the conducting wire may be reduced, and the conducting wire is arranged more neatly. When the DCDC module 200 is used in the charging system, the structure of the charging system is simplified, and assembly difficulty of the charging system is reduced.

In some implementations, the DC input terminal 231 is located between the DC output terminal 232 and the signal terminal 233, and the signal terminal 233 is located on a side that is of the DC input terminal 231 and that is close to the second sidewall 2152.

It may be understood that the DC output terminal 232 is located on one side of the DC input terminal 231. When the DC output terminal 232 is electrically connected to the to-be-charged device, a conducting wire may be arranged from one side. In this way, the conducting wire does not need to bypass the DC input terminal 231, the length of the conducting wire may be reduced, and the conducting wire is arranged more neatly. When the DCDC module 200 is used in the charging system, the structure of the charging system is simplified, and assembly difficulty of the charging system is reduced.

A projection of the DC input terminal 231 on the second sidewall 2152 is a first projection. A projection of the DC output terminal 232 on the second sidewall 2152 is a second projection. A projection of the DC input terminal 231 on the bottom wall 214 is a third projection, and a projection of the DC output terminal 232 on the bottom wall 214 is a fourth projection. The first projection and the second projection at least partially overlap, and the third projection and the fourth projection are staggered. In other words, the third projection and the fourth projection are disposed spaced from each other on the bottom wall 214.

It may be understood that in one aspect, compared with a solution in which the first projection and the second projection are staggered, the first projection and the second projection at least partially overlap. In a direction perpendicular to the bottom wall 214, a thickness of an overlapping part may be reduced, so that a thickness of the DCDC module 200 is smaller. In another aspect, the third projection and the fourth projection are staggered. In this way, the DC input terminal 231 and the DC output terminal 232 are disposed side by side, and are not stacked. This facilitates flat arrangement of the DCDC module 200. When the DCDC module 200 is electrically connected to the ACDC module 100, or the two DCDC modules 200 are electrically connected, there is no barrier between positions to be electrically connected. Therefore, the length of the conducting wire may be reduced, and the conducting wire is arranged more neatly.

In some implementations, a projection of the signal terminal 233 on the second sidewall 152 is a fifth projection, and a projection of the signal terminal 233 on the bottom wall 214 is a sixth projection. The second projection and the fifth projection at least partially overlap, and the fourth projection and the sixth projection are staggered. In this way, a thickness of the DCDC module 200 may be further reduced.

In some implementations, the DC input terminal 231, the DC output terminal 232, and the signal terminal 233 apply a floating structure. It may be understood that the DC input terminal 231, the DC output terminal 232, and the signal terminal 233 apply a floating structure, and when the DCDC module 200 is installed, this facilitates quick implementations of blind insertion, quick connection, or quick separation between the DCDC module 200 and various plugs. This reduces the risks of faults including shifting, skewness, misplacement, jamming, and the like during removal and insertion, and improves the reliability and service life of a device.

As shown in FIG. 7 and FIG. 8, in some implementations, a first groove 2141 may be disposed on the bottom wall 214 of the housing body 211. The bottom wall 214 may include a top surface 2142 and a bottom surface 2143 that are disposed back to each other, and the bottom surface 2143 is a surface of a side that is of the bottom wall and that is away from the circuit board 221. An opening of the first groove 2141 is located on the bottom surface 2143 of the bottom wall 214, and the second cover 213 is fastened to the bottom wall 214. The second cover 213 may be configured to cooperate with the first groove 2141 to form a runner. It may be understood that the runner may be configured to circulate a coolant. The coolant may be cooling water. The coolant is configured to take away heat of an integrated circuit when the circuit board assembly 220 works. Therefore, an objective of cooling is achieved and a fault of the circuit board assembly 220 caused by an excessively high operating temperature is avoided.

It may be understood that the DCDC module 200 applies a liquid cooling mode. Compared with an air cooling mode, the liquid cooling mode has a small noise, is not prone to dust accumulation, and does not have problems of salt spray corrosion and air channel blocking. The DCDC module 200 is easy to maintain and has a long service life.

In some implementations, a liquid inlet 1513 and a liquid outlet 1514 are disposed on the third sidewall 2153. The liquid inlet 1513 and the liquid outlet 1514 are disposed spaced from each other. The liquid inlet 1513 communicates with the runner, and the liquid outlet 1514 communicates with the runner. The coolant can flow into the runner through the liquid inlet 1513, flow to the liquid outlet 1514 through the runner, and flow out of the housing 210 through the liquid outlet 1514.

In some implementations, the DCDC module 200 may further include a guide pin 240. The guide pin 240 is connected to the first sidewall 2151, and the guide pin 240 is configured to assist in positioning the DCDC module 200 in the charging system. For a manner of disposing the guide pin 240, refer to a manner of disposing the guide pin 40 of the ACDC module 100.

In some implementations, the DCDC module 200 may further include a display component 250. For a manner of disposing the display component 250, refer to a manner of disposing the display component 50 of the ACDC module 100.

In some implementations, the DCDC module 200 may further include a handle 260. For a manner of disposing the handle 260, refer to a manner of disposing the handle 60 of the ACDC module 100.

In some implementations, the DCDC module 200 may further include a ground screw 270. For a manner of disposing the ground screw 270, refer to a manner of disposing the ground screw 70 of the ACDC module 100.

In some implementations, the DCDC module 200 may further include a waterproof film. For a manner of disposing the waterproof film, refer to a manner of disposing the ground screw 70 of the ACDC module.

It may be understood that the DCDC module 200 in this application includes the housing 210, the DC input terminal 231, the DC output terminal 232, and the signal terminal 233. The housing 210 includes the first sidewall 2151. A part of the DC input terminal 231, a part of the DC output terminal 232, and a part of the signal terminal 233 are all located inside the housing 210. The other part of the DC input terminal 231, the other part of the DC output terminal 232, and the other part of the signal terminal 233 all pass through the first sidewall 2151 and extend out of the housing 210. The DC input terminal 231, the DC output terminal 232, and the signal terminal 233 are arranged in the length direction of the first sidewall 2151.

It may be understood that the DC input terminal 231, the DC output terminal 232, and the signal terminal 233 of the DCDC module 200 are arranged in the length direction of the first sidewall 2151. This facilitates flat arrangement of the DCDC module 200. When a conducting wire is arranged between a plurality of DCDC modules 200, the conducting wire does not need to bypass a structure such as the DC input terminal 231, the DC output terminal 232, or the signal terminal 233. Therefore, the length of the conducting wire may be reduced, and the conducting wire is arranged more neatly. When the DCDC module 200 is used in the charging system, the structure of the charging system is simplified, and assembly difficulty of the charging system is reduced.

The foregoing specifically describes several implementations of the ACDC module 100 and the DCDC module 200 with reference to related accompanying drawings. The following describes an implementation of a charging system 1000 with reference to related accompanying drawings.

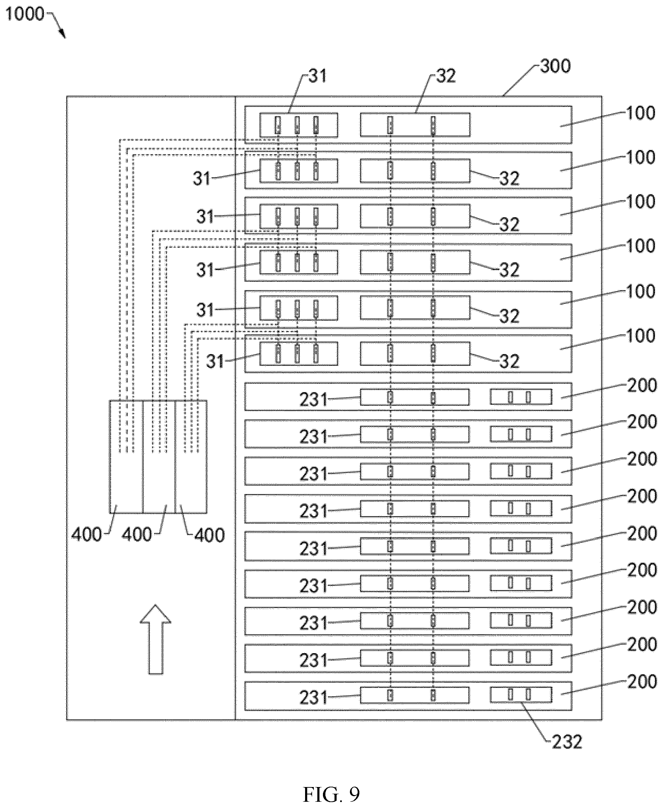

FIG. 9 is a schematic diagram of an implementation of the charging system 1000 according to this embodiment.

The charging system 1000 may be a charging pile of an electric vehicle, or may be an energy storage system. A charging pile is used as an example of the charging system 1000 in the embodiment shown in FIG. 9.

As shown in FIG. 9, the charging system 1000 includes an ACDC module 100, a DCDC module 200, an outer frame 300, and an alternating current power distribution module 400. The ACDC module 100, the DCDC module 200, and the alternating current power distribution module 400 are installed on the outer frame 300. In this case, FIG. 9 shows an electrical connection relationship among the ACDC module 100, the DCDC module 200, and the alternating current power distribution module 400 by using dashed lines. The dashed line may be a conducting wire used for electrical connection between modules.

The alternating current power distribution module 400 is electrically connected to the ACDC module 100. In addition, the alternating current power distribution module 400 is electrically connected to an external three-phase alternating current power supply (a direction of an arrow in FIG. 9 shows a connection direction of the three-phase alternating current power supply). The alternating current power distribution module 400 may be used as a switch of the charging system 1000. The alternating current power distribution module 400 is switched on and switched off to control the external three-phase alternating current power supply to be connected to the ACDC module 100. In some implementations, a lightning protection component may be further disposed in the alternating current power distribution module 400, to avoid damage to the charging system 1000 caused by lightning in a thunderstorm weather.

The ACDC module 100 is electrically connected to the DCDC module 200. The ACDC module 100 is configured to convert a three-phase alternating current into a direct current, and transmit the direct current to the DCDC module 200. The DCDC module 200 is configured to convert the direct current output by the ACDC module 100 into a direct current of a specified power. In some implementations, the DCDC module 200 is configured to convert a high-power direct current output by the ACDC module 100 into a direct current that may be output to an electric vehicle.

In some implementations, when the ACDC module 100 and the DCDC module 200 are installed on the outer frame 300 of the charging system 1000, the ACDC module 100 and the DCDC module 200 are arranged spaced from each other in a first direction, an AC input terminal 31 and a DC output terminal 32 of the ACDC module 100 are arranged spaced from each other in a second direction, a DC input terminal 231 and a DC output terminal 232 of the DCDC module 200 are arranged spaced from each other in the second direction, and the first direction and the second direction are disposed at an included angle. The DC output terminal 32 of the ACDC module 100 and the DC input terminal 231 of the DCDC module 200 are oppositely disposed (as shown in FIG. 9).

It may be understood that the DC output terminal 32 of the ACDC module 100 and the DC input terminal 231 of the DCDC module 200 in the charging system 1000 may be oppositely disposed. In this way, when a conducting wire is arranged to electrically connect the ACDC module 100 and the DCDC module 200, there is no barrier between the modules, and the conducting wire may not need to bypass. Therefore, a length of the conducting wire between the ACDC module 100 and the DCDC module 200 may be reduced. This helps simplify a structure of the charging system 1000, and reduce assembly difficulty of the charging system 1000.

The charging system 1000 may include one or more ACDC modules 100, DCDC modules 200, and alternating current power distribution modules 400. This is not limited in this application.

In some implementations, when the charging system 1000 includes a plurality of ACDC modules 100, AC input terminals 31 of adjacent ACDC modules 100 are connected in parallel through a conducting wire, and DC output terminals 32 of adjacent ACDC modules 100 may also be connected in parallel through a conducting wire. The AC input terminals 31 of adjacent ACDC modules 100 may be oppositely disposed, and the DC output terminals 32 of adjacent ACDC modules 100 may also be oppositely disposed. In this way, a length of a conducting wire for electrical connection between adjacent ACDC modules 100 may be reduced.

In some implementations, when the charging system 1000 includes a plurality of DCDC modules 200, DC input terminals 231 of adjacent DCDC modules 200 are connected in parallel through a conducting wire, and DC output terminals 232 of adjacent DCDC modules 200 may also be connected in parallel through a conducting wire. The DC input terminals 231 of adjacent DCDC modules 200 may be oppositely disposed, and the DC output terminals 232 of adjacent DCDC modules 200 may also be oppositely disposed. In this way, a length of a conducting wire for electrical connection between adjacent DCDC modules 200 may be reduced.

In some implementations, the charging system 1000 may not include the alternating current power distribution module 400.

It should be noted that embodiments in this application and features in embodiments may be mutually combined in the case of no conflict and any combination of features in different embodiments also falls within the protection scope of this application. In other words, the foregoing described plurality of embodiments may be further combined based on an actual requirement in any manner.

It should be noted that all the foregoing accompanying drawings are examples of this application, and do not represent actual sizes of products. In addition, a size proportion relationship between components in the accompanying drawings is not intended to limit an actual product in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An ACDC module (100), comprising a housing (10), an AC input terminal (31), a DC output terminal (32), and a signal terminal (33), wherein
the housing (10) comprises a first sidewall (151), a part of the AC input terminal (31), a part of the DC output terminal (32), and a part of the signal terminal (33) are all located inside the housing (10), the other part of the AC input terminal (31), the other part of the DC output terminal (32), and the other part of the signal terminal (33) all pass through the first sidewall (151) and extend out of the housing (10), and the AC input terminal (31), the DC output terminal (32), and the signal terminal (33) are arranged in a length direction of the first sidewall (151).

2. The ACDC module (100) according to claim 1, wherein the AC input terminal (31) comprises a first phase current input port (311), a second phase current input port (312), and a third phase current input port (313) that are disposed spaced from one another, and the first phase current input port (311), the second phase current input port (312), and the third phase current input port (313) are arranged in the length direction of the first sidewall (151).

3. The ACDC module (100) according to claim 2, wherein the DC output terminal (32) comprises a positive output port (321) and a negative output port (322) that are disposed spaced from each other, and the positive output port (321) and the negative output port (322) are arranged in the length direction of the first sidewall (151).

4. The ACDC module (100) according to any one of claims 1 to 3, wherein the DC output terminal (32) is located between the AC input terminal (31) and the signal terminal (33).

5. The ACDC module (100) according to any one of claims 1 to 3, wherein the housing (10) comprises a second sidewall (152) and a bottom wall (14), the second sidewall (152) is connected to the first sidewall (151), the second sidewall (152) and the first sidewall (151) are disposed at an included angle, and the bottom wall (14) is connected to the first sidewall (151) and the second sidewall (152), and is located at a bottom of the first sidewall (151) and a bottom of the second sidewall (152); and
a projection of the AC input terminal (31) on the second sidewall (152) is a first projection, a projection of the DC output terminal (32) on the second sidewall (152) is a second projection, a projection of the AC input terminal (31) on the bottom wall (14) is a third projection, a projection of the DC output terminal (32) on the bottom wall (14) is a fourth projection, the first projection and the second projection at least partially overlap, and the third projection and the fourth projection are staggered.

6. The ACDC module (100) according to claim 5, wherein a projection of the signal terminal (33) on the second sidewall (152) is a fifth projection, a projection of the signal terminal (33) on the bottom wall (14) is a sixth projection, the second projection and the fifth projection at least partially overlap, and the fourth projection and the sixth projection are staggered.

7. The ACDC module (100) according to any one of claims 1 to 3, wherein the ACDC module (100) comprises a circuit board (21), the circuit board (21) is disposed inside the housing (10), and the AC input terminal (31), the DC output terminal (32), and the signal terminal (33) are electrically connected to the circuit board (21);
a bottom wall (14) of the housing (10) comprises a top surface (142) and a bottom surface (143) that are disposed back to each other, the bottom surface (143) is a surface of a side that is of the bottom wall (14) and that is away from the circuit board (21), a first groove (141) is disposed on the bottom wall (14), an opening of the first groove (141) is located on the bottom surface (143) of the bottom wall (14), the housing (10) further comprises a second cover (13), and the second cover (13) is fastened to the bottom wall (14) and covers the first groove (141); and
the second cover (13) cooperates with the first groove (141) to form a runner, and the runner is configured to circulate a coolant to cool the circuit board (21).

8. The ACDC module (100) according to claim 7, wherein the housing (10) comprises a third sidewall (153), the first sidewall (151) and the third sidewall (153) are oppositely disposed spaced from each other, a second sidewall (152) of the housing (10) is connected between the first sidewall (151) and the third sidewall (153), and the bottom wall (14) is connected to the first sidewall (151), the second sidewall (152), and the third sidewall (153), and is located at a bottom of the first sidewall (151), a bottom of the second sidewall (152), and a bottom of the third sidewall (153);
a liquid inlet (1511) and a liquid outlet (1512) are disposed on the third sidewall (153), the liquid inlet (1511) and the liquid outlet (1512) are disposed spaced from each other, the liquid inlet (1511) communicates with the runner, and the liquid outlet (1512) communicates with the runner; and
the coolant can flow into the runner through the liquid inlet (1511), flow to the liquid outlet (1512) through the runner, and flow out of the housing (10) through the liquid outlet (1512).

9. A DCDC module (200), comprising a housing (210), a DC input terminal (231), a DC output terminal (232), and a signal terminal (233), wherein
the housing (210) comprises a first sidewall (2151), a part of the DC input terminal (231), a part of the DC output terminal (232), and a part of the signal terminal (233) are all located inside the housing (210), the other part of the DC input terminal (231), the other part of the DC output terminal (232), and the other part of the signal terminal (233) all pass through the first sidewall (2151) and extend out of the housing (210), and the DC input terminal (231), the DC output terminal (232), and the signal terminal (233) are arranged in a length direction of the first sidewall (2151).

10. The DCDC module (200) according to claim 9, wherein the DC input terminal (231) comprises a positive input port (2311) and a negative input port (2312) that are disposed spaced from each other, and the positive input port (2311) and the negative input port (2312) are arranged in the length direction of the first sidewall (2151).

11. The DCDC module (200) according to claim 9 or 10, wherein the DC output terminal (232) comprises a positive output port (2321) and a negative output port (2322) that are disposed spaced from each other, and the positive output port (2321) and the negative output port (2322) are arranged in the length direction of the first sidewall (2151).

12. The DCDC module (200) according to claim 9 or 10, wherein the housing (210) comprises a second sidewall (2152) and a bottom wall (214), the second sidewall (2152) is connected to the first sidewall (2151), the second sidewall (2152) and the first sidewall (2151) are disposed at an included angle, and the bottom wall (214) is connected to the first sidewall (2151) and the second sidewall (2152), and is located at a bottom of the first sidewall (2151) and a bottom of the second sidewall (2152); and
a projection of the DC input terminal (231) on the second sidewall (2152) is a first projection, a projection of the DC output terminal (232) on the second sidewall (2152) is a second projection, a projection of the DC input terminal (231) on the bottom wall (214) is a third projection, a projection of the DC output terminal (232) on the bottom wall (214) is a fourth projection, the first projection and the second projection at least partially overlap, and the third projection and the fourth projection are staggered.

13. The DCDC module (200) according to claim 9 or 10, wherein the DCDC module (200) comprises a circuit board (221), the circuit board (221) is disposed inside the housing (210), and the DC input terminal (231), the DC output terminal (232), and the signal terminal (233) are electrically connected to the circuit board (221);
a bottom wall (214) of the housing (210) comprises a top surface (2142) and a bottom surface (2143) that are disposed back to each other, the bottom surface (2143) is a surface of a side that is of the bottom wall (214) and that is away from the circuit board (221), a first groove (2141) is disposed on the bottom wall (214), an opening of the first groove (2141) is located on the bottom surface (2143) of the bottom wall (214), the housing (210) further comprises a second cover (213), and the second cover (213) is fastened to the bottom wall (214) and covers the first groove (2141); and
the second cover (213) cooperates with the first groove (2141) to form a runner, and the runner is configured to circulate a coolant to cool the circuit board (221).

14. The DCDC module (200) according to claim 13, wherein the housing (210) comprises a third sidewall (2153), the first sidewall (2151) and the third sidewall (2153) are oppositely disposed spaced from each other, a second sidewall (2152) of the housing (210) is connected between the first sidewall (2151) and the third sidewall (2153), and the bottom wall (214) is connected to the first sidewall (2151), the second sidewall (2152), and the third sidewall (2153), and is located at a bottom of the first sidewall (2151), a bottom of the second sidewall (2152), and a bottom of the third sidewall (2153);
a liquid inlet (1513) and a liquid outlet (1514) are disposed on the third sidewall (2153), the liquid inlet (1513) and the liquid outlet (1514) are disposed spaced from each other, the liquid inlet (1513) communicates with the runner, and the liquid outlet (1514) communicates with the runner; and
the coolant can flow into the runner through the liquid inlet (1513), flow to the liquid outlet (1514) through the runner, and flow out of the housing (210) through the liquid outlet (1514).

15. A charging system (1000), comprising an outer frame, the ACDC module (100) according to any one of claims 1 to 8, and the DCDC module (200) according to any one of claims 9 to 14, wherein the ACDC module (100) and the DCDC module (200) are installed on the outer frame (300).
